# EUROPEAN PATENT APPLICATION

(11) **EP 1 912 263 A2**
(43) Date of publication of application: **16.04.2008**
(21) Application number: 07006710.3
(22) Date of filing: 30.03.2007
(51) Int. Cl.: H01L 33/00

(54) **High power light emitting diode package**

(30) Priority: 11.10.2006 KR 20060098861
(71) Applicant: Alti-electronics Co., Ltd., Cheoin-gu, Yongin-si, Gyeonggi-do (KR)
(72) Inventor: Kim, Dong Soo, 90-1, Bongmyung-ri, Gyeonggi-do (KR); Kim, Dong Sel, Yeongtong-gu, Suwon-si, Gyeonggi-do (KR)
(74) Representative: Grünecker, Kinkeldey, Stockmair & Schwanhäusser Anwaltssozietät

(57) **Abstract**

A high power light emitting diode ("LED") package is disclosed. The high power LED package includes a housing made of an insulating material and having a cavity in its central portion; a lead frame made of a conductive material, including an inner lead exposed by the cavity of the housing and an outer lead extending outside the housing; a heat sink above which the inner lead is placed and having a portion exposed by the cavity of the housing; an LED chip mounted on the exposed portion of the heat sink and electrically connected to the inner lead; a lens portion coupled to the housing to cover the cavity of the housing; and an insulating adhesive sheet interposed between the inner lead and the heat sink for electrically insulating and thermally coupling the inner lead and the heat sink.

## Description

### CROSS-REFERENCE TO RELATED APPLICATION

This application claims priority to and the benefit of Korean Patent Application No. 2006-98861, filed October 11, 2006, the disclosure of which is incorporated herein by reference in its entirety.

### BACKGROUND OF THE INVENTION

### 1. Field of the Invention

The present invention relates to a light emitting diode ("LED") package and, more particularly, to a high power LED package.

### 2. Description of the Related Art

An LED is a semiconductor which emits light of various colors when an electric current is applied thereto. A color of light emitted from the LED depends on a chemical component which constitutes the LED, and the LED is increasingly in demand due to advantages such as a long lifespan, low power consumption, and an excellent initial driving characteristic. The LED generates lots of heat since it can not transform an electric current into light 100%. Components of the LED get stress due to a difference between their thermal expansion coefficients when the generated heat is not released. Thus, the LED employs a metal lead frame or a heat sink for releasing the generated heat.

Recently, the LED is employed as a lighting device or a backlight for a large-sized liquid crystal display ("LCD") device. The LED used in those requires a high power performance, and a high power LED needs a more excellent heat releasing performance.

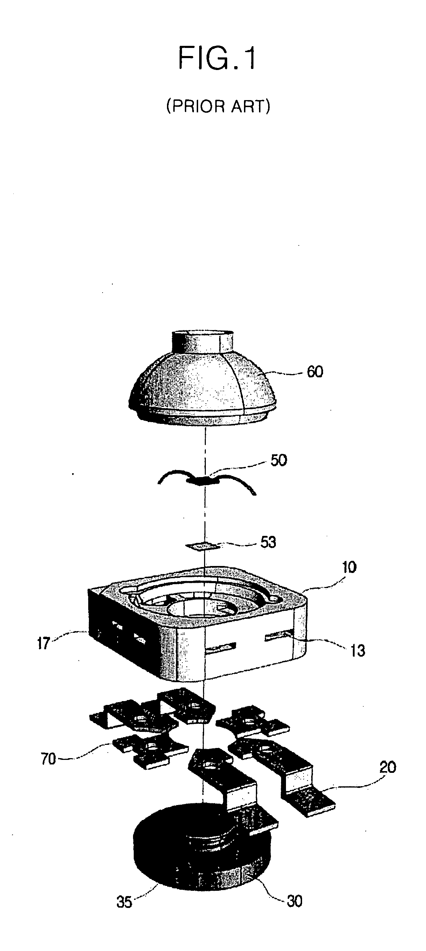

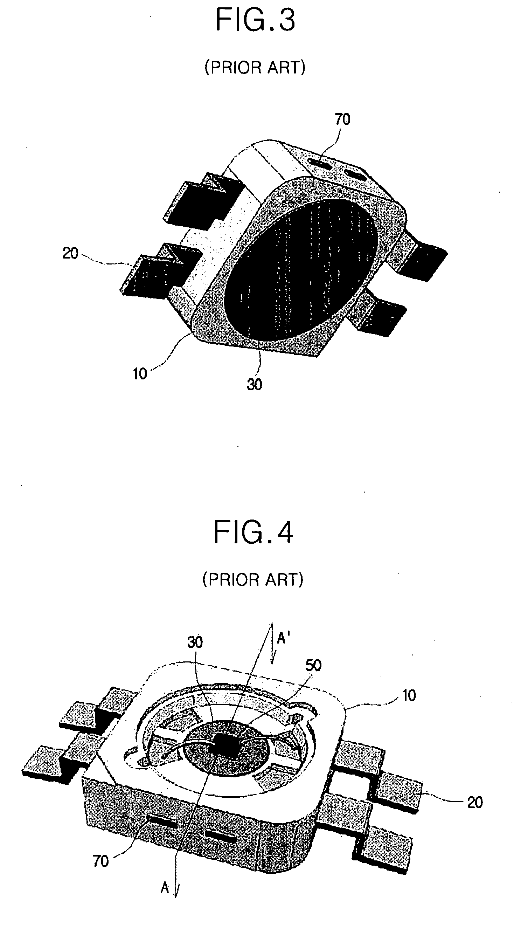

A conventional LED package is described below with reference to FIGs. 1 to 5.

The conventional LED package comprises an LED chip 50 made of an InGaN semiconductor, a heat sink 30 which the LED chip 50 is placed on, serves to release heat and is made of a metal slug, a plurality of lead frames 20 which serve as electrode terminals for supplying an electrical power to the LED chip 50, a housing for fixing and accommodating the lead frames 3, a lens 60 which covers the housing 10 to protect the LED chip 50 and has the LED chip 5 to have optical characteristics.

The lead frame 20 which is made of a conductive metal to serve as an electrode terminal is inserted into a lead hole 13 of the housing 10 which is molded of plastic-like resin or is formed integrally with the housing by arranging a mold for forming the housing 10 and injecting plastic-like resin into the mold.

The heat sink 30 is inserted into a central hole of the housing 10, and the LED chip 50 is mounted on a top surface of the heat sink 30. The LED chip 50 is attached to a sub mount 53 by a soldering process, and the sub mount 53 having the LED chip 50 is placed on the top surface of the heat sink 30. Here, the LED chip 50 is electrically connected to the lead frames 20 through conductive wires.

After the LED chip 50 is wire-bonded with the lead frames 20, the lens 60 made of a plastic-like material is fixed to an upper portion of the housing 10 by using silicon or epoxy, thereby completing the LED package. Of course, before fixing the lens 60 to the housing 10, liquid resin such as epoxy may be filled in the hole of the housing 10 which accommodates the LED chip 50 and then cured to seal the LED chip 50 and the wires. The liquid resin may contain a phosphor corresponding to a color of light emitted from the LED chip.

In order to couple the heat sink 30 to the housing 10, the heat sink 30 has a central protruding portion which is formed to have a step portion by using a cutting technique, and the housing 10 has a groove 15 formed on its bottom corresponding to the step portion. The heat sink 30 and the housing 10 are coupled to each other by inserting and fitting the heat sink 30 into the groove 15 of the housing 10. In addition, a groove 35 is formed on a circumference of the central protruding portion of the heat sink 30, and the housing 10 has tie holes 17 formed on its side. The heat sink 30 and the housing 10 are coupled to each other such that ties 17 are inserted into the tie holes 17 and the other ends of the ties 70 are fitted into the groove 35.

However, the coupling method described above is not suitable for mass production because an insertion location may change according to the insertion strength and the housing 10 may easily be transformed. In addition, a step difference between the lead frame 20 and the bottom of the heat sink 30 may occur when the LED package is mounted on a printed circuit board ("PCB") by using a surface-mount technology ("SMT"), so that the bottom of the heat sink 30 is not closely mounted on the PCB, leading to a low heat releasing performance.

Also, in the coupling method using the ties 70, the step portion and the groove 35 should be formed in the heat sink 30 by using a cutting technique, and so the precise assembly is required, leading to the high manufacturing cost.

### SUMMARY OF THE INVENTION

It is an object of the present invention to provide a high power LED package in which the heat sink, the lead frames and the housing can be efficiently coupled without cutting the heat sink nor using a discrete coupling means such as the ties.

It is another object of the present invention to provide a high power LED package which is suitable for mass production and is low in manufacturing cost because it does not need a process for fitting the heat sink into the housing.

It is still another object of the present invention to provide a high power LED package with an excellent heat releasing performance.

It is yet another object of the present invention to provide a high power LED package in which a place where a discrete Zener diode is placed is formed.

One aspect of the present invention provides a high power light emitting diode (LED) package, comprising: a housing made of an insulating material and having a cavity in its central portion; a lead frame made of a conductive material, including an inner lead exposed by the cavity of the housing and an outer lead extending outside the housing; a heat sink above which the inner lead is placed and having a portion exposed by the cavity of the housing; an LED chip mounted on the exposed portion of the heat sink and electrically connected to the inner lead; a lens portion coupled to the housing to cover the cavity of the housing; and an insulating adhesive sheet interposed between the inner lead and the heat sink for electrically insulating and thermally coupling the inner lead and the heat sink.

The insulating adhesive sheet comprises a base film made of an insulating material and adhesive layers arranged on a top and a bottom of the base film.

The base film is a polyimide film having a glass transition temperature of more than 260°C.

The adhesive layers are formed by coating a polyimide-like adhesive containing an acid terminal group.

A filler having thermal conductivity and non conductivity is added in the base film and the adhesive layers.

The filler comprises one of silica, alumina, and aluminum nitride (AIN).

The LED chip is adhered to the exposed portion of the heat sink by using a non-conductive paste.

The lens portion comprises a molding portion which is formed by filling insulating resin in the cavity of the housing to seal the LED chip and a lens for covering the molding portion.

The molding portion contains a phosphor corresponding to a color of light emitted from the LED chip.

The LED chip is electrically connected to the inner lead by using a wire bonding or a flip chip bonding.

The cavity of the housing has a cup shape whose diameter is increased as it is higher.

A reflecting material is coated on or a reflector made of a metallic material is coupled to an inner side of the cavity of the housing.

The housing has a Zener diode mounting portion in which a Zener diode is mounted.

Another aspect of the present invention provides a light emitting diode (LED) package, comprising: a housing including an LED chip mounting portion, lead frame contact portions for electrical contact with an LED chip, a Zener diode mounting portion, a lead frame connecting portion formed on its side, and a heat sink adhering portion, wherein the lead frame connecting portion and the heat sink adhering portion have a cavity; a lead frame coupled through the lead frame connecting portion; a heat sink adhered through the heat sink adhering portion; and an insulating adhesive sheet for adhering the lead frame and the heat sink.

The LED chip mounting portion has a concave shape whose diameter is smaller as it is lower.

The lead frame contact portion and the Zener diode mounting portion are patterned into one area.

The LED chip is electrically connected through its bottom portion.

### BRIEF DESCRIPTION OF THE DRAWINGS

The above and other features of the present invention will be described in reference to certain exemplary embodiments thereof with reference to the attached drawings in which:
FIG. 1 is an exploded perspective view illustrating a high power LED package according to a conventional art;
FIG. 2 is an exploded perspective view illustrating the high power LED package of FIG. 1 which is shown from a bottom;
FIG. 3 is a perspective view illustrating the high power LED package of FIG. 1 which is shown from a bottom;
FIG. 4 is a perspective view illustrating the high power LED package in which a lens is removed according to the conventional art;
FIG. 5 is a cross-sectional view taken along line A-A' of FIG. 4;
FIG. 6 is a perspective view illustrating a high power LED package in which a lens is removed according to a first exemplary embodiment of the present invention;
FIG. 7 is a cross-sectional view taken along line B-B' of FIG. 6;
FIG. 8 is a perspective view illustrating the high power LED package according to the first embodiment of the present invention, which is shown from a bottom;
FIG. 9 is a partial exploded perspective view illustrating the high power LED package of FIG. 6;
FIG. 10 is a partial exploded perspective view illustrating the high power LED package of FIG. 9 which is shown from a bottom.
FIG. 11 is a perspective view illustrating a high power LED package according to a second exemplary embodiment of the present invention;
FIG. 12 is an exploded perspective view illustrating the high power LED package of FIG. 11;
FIG. 13 is a cross-sectional view illustrating the high power LED package of FIG. 11; and
FIG. 14 is a perspective view illustrating a high power LED package according to a third exemplary embodiment of the present invention.

### DETAILED DESCRIPTION OF THE INVENTION

Reference will now be made in detail to the embodiments of the present invention, examples of which are illustrated in the accompanying drawings, wherein like reference numerals refer to the like elements throughout. The embodiments are described below in order to explain the present invention by referring to the figures.

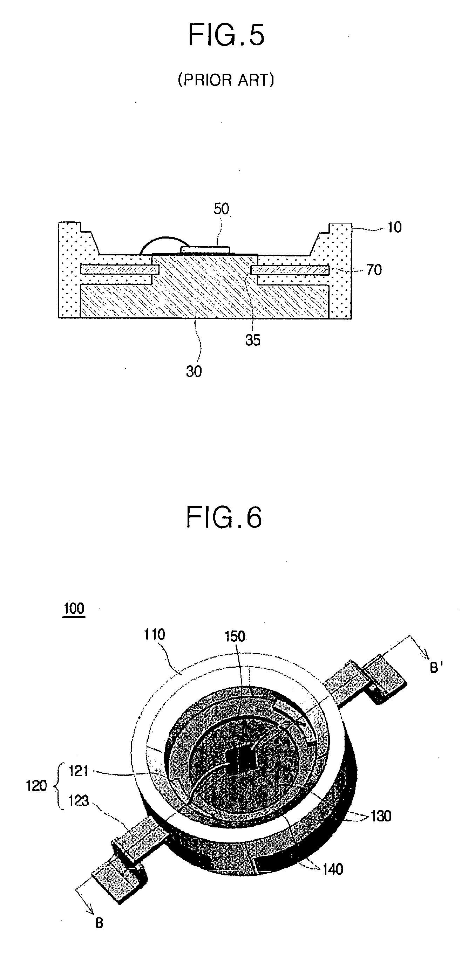

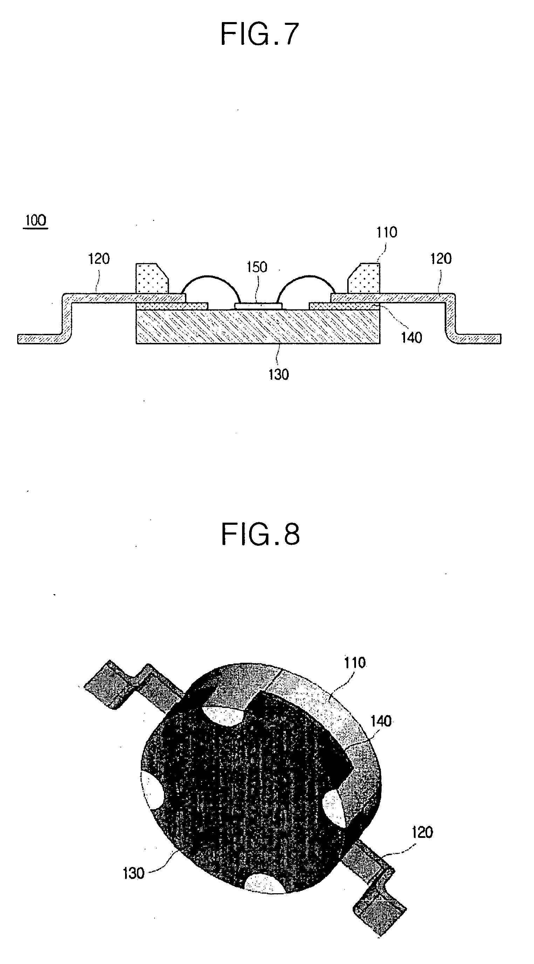

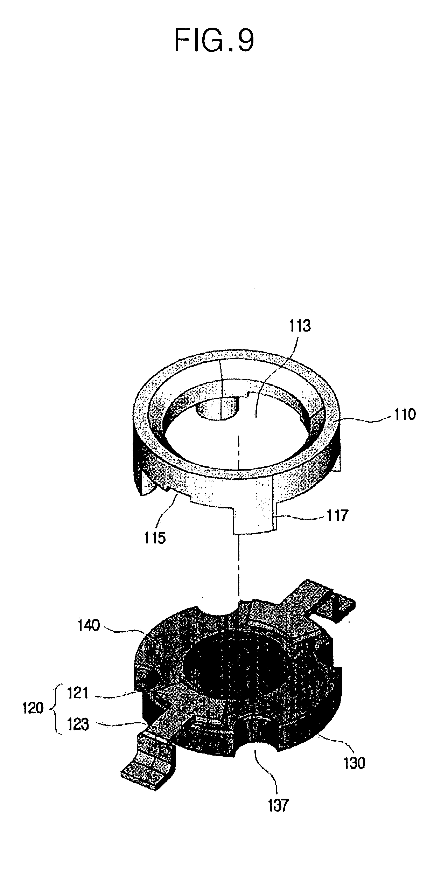

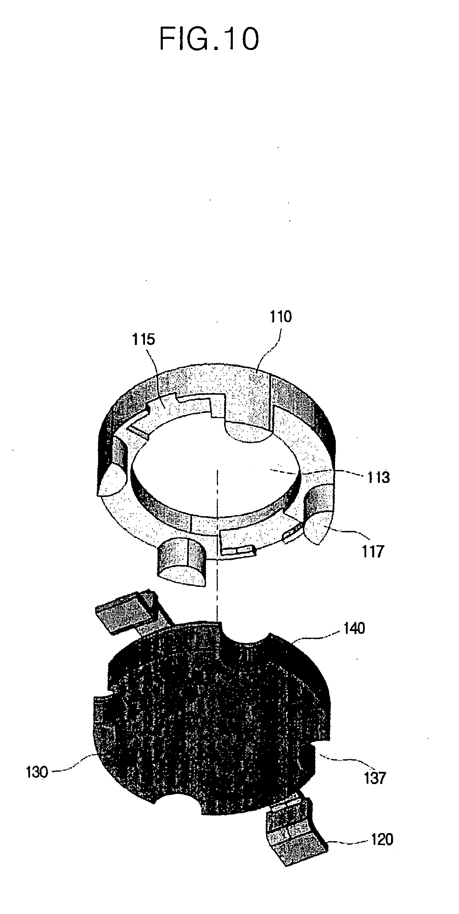

FIG. 6 is a perspective view illustrating a high power LED package in which a lens is removed according to a first exemplary embodiment of the present invention. FIG 7 is a cross-sectional view taken along line B-B' of FIG. 6. FIG 8 is a perspective view illustrating the high power LED package according to the first embodiment of the present invention, which is shown from a bottom. FIG. 9 is a partial exploded perspective view illustrating the high power LED package of FIG. 6. FIG 10 is a partial exploded perspective view illustrating the high power LED package of FIG. 9, which is shown from a bottom.

The high power LED package according to the first exemplary embodiment of the present invention is described in detail with reference to FIGs. 6 to 10.

The high power LED package 100 according to the first exemplary embodiment of the present invention comprises a housing 110, a lead frame 120, an insulating adhesive sheet 140, a heat sink 130, an LED chip 150, and a lens 150.

The LED package 100 may further comprise a Zener diode mounting portion (not shown) for mounting a Zener diode.

The Zener diode mounting portion may be realized by forming a cavity in the housing 110 and is preferably formed nearby an inner lead 121 in which the lead frame 120 is exposed for electrical contact.

The housing 110 is made of an insulating injection material and has a cavity 113 formed in its central portion. Here, a reflecting material may be coated on or a reflector made of a metallic material may be coupled to an inner side of the cavity of the housing A lead frame pair 120 serves as an electrode terminal, is made of a conductive material and is partially covered with the housing 110. The lead frame 120 comprises an inner lead 121 which is exposed by the cavity 113 and an outer lead 123 which extends outside the housing 110 to receive an electrical power. Here, the inner lead 121 may be electrically connected to the LED chip 150 by using a wire bonding or a flip chip bonding. The heat sink 130 has a disk-like shape in general. The lead frame 120 is placed on the heat sink 130 such that the insulating adhesive sheet 140 of a ring-like shape is attached on the heat sink 30 and the inner lead 121 is attached onto the insulating adhesive sheet 140.

The heat sink 130 onto which the ring-shaped insulating adhesive sheet 140 and the lead frame 120 are adhered along an edge of the housing 110 is attached to the housing 110, whereby a central portion of the heat sink 130 is exposed by the cavity 113 of the housing 110.

The inner lead 121 is coupled to a lead groove 115 formed in a lower portion of the housing 110 so that the remaining portion of the insulating adhesive sheet 140 excluding a portion attached to the inner lead 121 can be adhered to the housing 110. The housing 110 has a protruding portion 117 which is formed to protrude downward, and the heat sink 130 and the insulating adhesive sheet 140 have corresponding coupling grooves 137, so that the housing 110 and the heat sink 130 can be firmly coupled to each other by fitting the protruding portion 117 into the coupling grooves 137.

The LED chip 150 is usually placed on a sub mount to be mounted on the exposed portion of the heat sink 130. It may be adhered directly to the exposed portion of the heat sink 130 by using a non-conductive paste. The LED chip 150 mounted on the heat sink 130 is bonded to the inner lead 121 by a wire made of a conductive material such as aurum (Au).

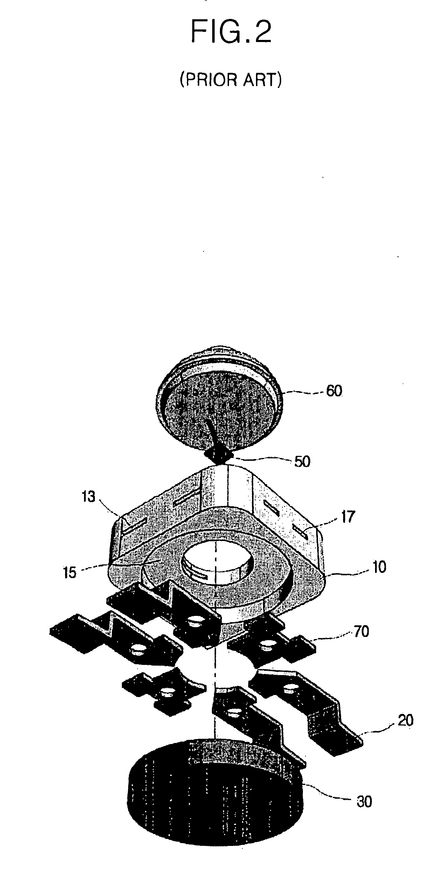

Thereafter, a lens (see 60 of FIGS. 1 and 2) made of a plastic-like material is fixed to the housing 110 by using silicon or epoxy, thereby completing the high power LED package 100. Of course, before fixing the lens to the housing 110, liquid resin such as epoxy may be filled in the cavity of the housing 110 which accommodates the LED chip 150 and then cured to seal the LED chip 150 and the wires. The liquid resin may contain a phosphor corresponding to a color of light emitted from the LED chip to thereby change a color, i.e., a wavelength of light emitted from the high power LED package 100.

As the heat sink 130 which serves as a heat releasing means, a metal slug made of copper (Cu) is used. The lead frame 120 is made of a conductive metal such as copper (Cu) and argentum (Ag) to supply an electrical power to the LED chip 150. Thus, the insulating adhesive sheet 140 which is interposed between the heat sink 130 and the lead frame 120 to couple them is required to have a material and a structure which can electrically insulate and thermally couple the heat sink 130 and the lead frame 120.

If the liquid resin such as epoxy is filled in the cavity 113 of the housing 110 which accommodates the LED chip 150 as described above, required is thermal endurance that can endure a high temperature of the liquid resin and heat generated from the LED package 150. Typically, thermal endurance of about more than 260°C is required.

As a component which satisfies such requirements and couples the lead frame and the heat sink, the insulating adhesive sheet is used in the present invention. The insulating adhesive sheet comprises a base film made of an insulating material and adhesive layers which are attached on and beneath the base film.

A double sided tape for a lead on chip ("LOC") which adheres a semiconductor chip and a lead frame which is used for semiconductor packaging may be used as the insulating adhesive sheet by changing the thickness and an ingredient of the adhesive layers to be suitable for adhering and coupling characteristics of the lead frame and the heat sink of the LED package 150. The double sided tape for the LOC has thermal endurance of more than 300°C and the thickness of 100 to 300 µm, and thus it is suitable for being used as the insulating adhesive sheet.

In the first exemplary embodiment of the present invention, the insulating adhesive sheet 140 of a three-layer structure in which an adhesive is coated on a top and a bottom of the base film made of rigid polyimide is used.

A polyimide-like film having a glass transition temperature of more than 260°C may be used as the base film, and the adhesive layer may be made of polyether amide, epoxy resin or thermoplastic polyimide. Also, the adhesive layer may be formed by coating a polyimide-like adhesive which contains an acid terminal group having strong coupling force onto a surface of a metallic material in light of adhesive force between the lead frame 120 and the heat sink 130.

The insulating adhesive sheet 140 having such a material and structure has the sufficient electrical insulating property, but when the total thickness of the insulating adhesive sheet 140 is in a range between 100 µm to 300 µm, i.e., as the thickness is thicker, it may not have thermal conductivity to sufficiently release heat generated from the LED chip.

In this regard, the insulating adhesive sheet 400 may further comprise a filler having thermal conductivity added in the base film and the adhesive layer to improve its thermal conductivity. As the filler, a particle of a non-conductive component such as silica, alumina and aluminum nitride (AIN) may be added.

Since by using the insulating adhesive sheet 140, the lead frame 120 is adhered to the heat sink 130 and the heat sink 130 is adhered to the housing 110 as described above, there is no need for the process for forming the step portion by using the cutting process so that the central portion of the heat sink can protrude, forming the groove in the lower portion of the housing, and fitting the heat sink 30 into the groove of the housing as in the conventional art (see FIGs. 1 to 5). Also, there is no need for the additional coupling means which couples the housing and the heat sink by fitting the tie into the groove formed on the circumference of the protruding portion of the heat sink.

That is, the conventional art requires the precise cutting process for forming the protruding portion and the groove in the heat sink and the additional coupling means such as the tie, but according to the first exemplary embodiment of the present invention, since the lead frame 120 and the housing 110 are adhered to the disc-like shaped heat sink by using the insulating adhesive sheet 140 and the heat sink 130 is made by a simple punching process, there is no need for the process for fitting the housing into the heat sink, whereby it is easy to assemble, leading to the mass production and low manufacturing cost.

Also, when the LED package 100 is mounted on the PCB (not shown) by using the SMT, a heat releasing performance is significantly improved since the area size of the bottom of the heat sink 130 which contacts the PCB is increased.

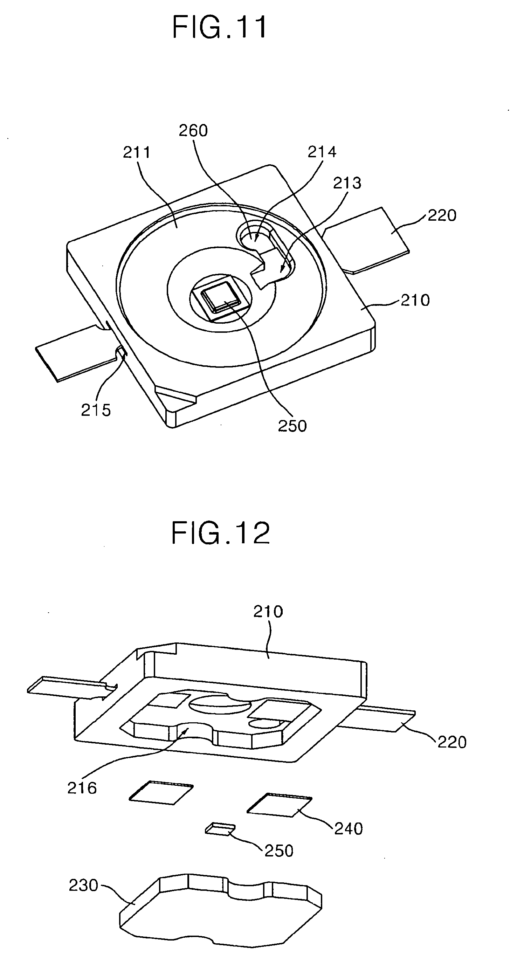

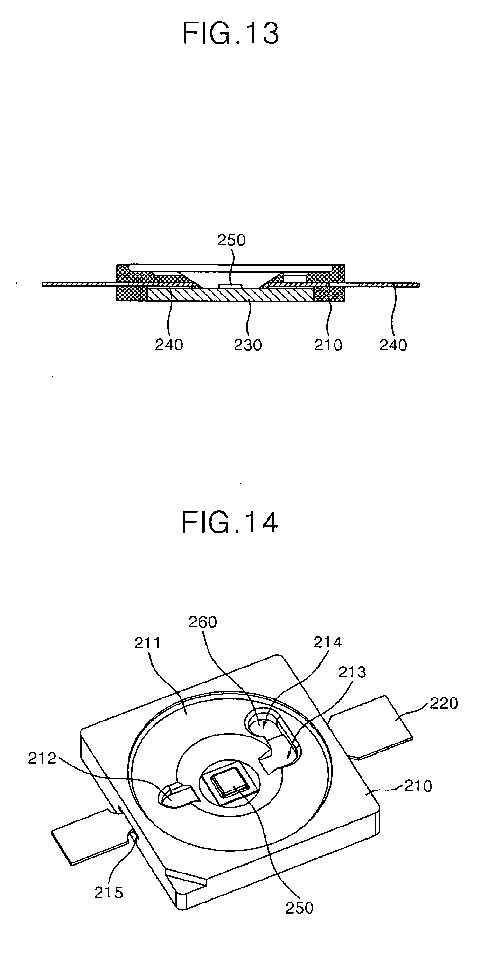

FIG. 11 is a perspective view illustrating a high power LED package according to a second exemplary embodiment of the present invention. FIG. 12 is an exploded perspective view illustrating the high power LED package of FIG. 11, and FIG 13 is a cross-sectional view illustrating the high power LED package of FIG. 11.

That is, the high power LED package according to the second exemplary embodiment of the present invention further comprises a zener diode to protect it from an electrostatic discharge (ESD). To this end, the high power LED package has a zener diode mounting portion.

Referring to FIGs. 11 and 13, a housing 210 of the high power LED package comprises an LED chip mounting portion 211, lead frame contact portions 212 and 213 which are connected to bonding wires for electrical contact with the LED chip, a zener diode mounting portion 214 in which a zener diode 260 is mounted, a lead frame connecting portion 215 formed on its side, and a heat sink adhering portion 216. Here, the lead frame connecting portion 215 and the heat sink adhering portion 216 have a cavity.

The Zener diode mounting portion 214 may be arranged nearby the LED chip mounting portion 211 in which the LED chip 250 is mounted and the lead frame contact portions 212 and 213 for electrical contact. The lead frame contact portion 213 and the Zener diode mounting portion 214 are separately formed, but they may be simultaneously patterned into one area.

A lead frame 220 is connected through the lead frame connecting portion 215 of the housing 210, and the heat sink 230 is adhered to the lead frame 220 and the heat sink adhering portion 216. Here, since the lead frame 220 and the heat sink 230 contact, an insulating adhesive sheet 240 interposed between the lead frame 220 and the heat sink 230 thermally couples the lead frame 220 and the heat sink 230 while electrically insulating them.

The LED chip mounting portion 211 may be patterned into a concave shape whose diameter is smaller as it is lower to increase light emitting efficiency of the LED chip 250. Since the Zener diode mounting portion 214 for mounting the Zener diode 260 is formed, a processing time for mounting the Zener diode is reduced, thereby maximizing processing efficiency.

FIG. 14 is a perspective view illustrating a high power LED package according to a third exemplary embodiment of the present invention.

The high power LED package of FIG. 14 has a configuration that the lead frame contact portion 212 which is not nearby the Zener diode mounting portion 214 is removed and the lead frame 220 inserted through the lead frame connecting portion 215 is electrically connected to a bottom portion of the LED chip 250, compared to the LED package of FIG. 11.

As can be seen in FIG. 14, the shape and coupling structure of the housing 210, the lead frame 220 and the heat sink 230 can be modified to various forms if it has a structure that the lead frame 220 and the heat sink 230 are adhered by the insulating adhesive sheet 240.

As described above, according to the exemplary embodiments of the present invention, since the insulating adhesive sheet is used as the coupling means of the heat sink and the lead frame (and housing), the heat sink, the lead frame and the housing can efficiently be coupled without using the process for cutting the heat sink and the additional coupling means such as the tie.

Also, since the heat sink fabricated by the punching process is adhered to the lead frame and the housing by the insulating adhesive sheet, there is no need for the process for fitting the housing into the heat sink, thereby achieving mass production and the low manufacturing cost.

In addition, since the insulating adhesive sheet having excellent thermal conductivity is used and the LED package 100 is mounted on the PCB (not shown) by using the SMT, the area size of the bottom of the heat sink which contacts the PCB is increased, thereby significantly increasing the heat releasing performance.

Although the present invention has been described with reference to certain exemplary embodiments thereof, it will be understood by those skilled in the art that a variety of modifications and variations may be made to the present invention without departing from the spirit or scope of the present invention defined in the appended claims, and their equivalents.

## Claims

1. A high power light emitting diode ("LED") package, comprising:
a housing made of an insulating material and having a cavity in its central portion;
a lead frame made of a conductive material, including an inner lead exposed by the cavity of the housing and an outer lead extending outside the housing;
a heat sink above which the inner lead is placed and having a portion exposed by the cavity of the housing;
an LED chip mounted on the exposed portion of the heat sink and electrically connected to the inner lead;
a lens portion coupled to the housing to cover the cavity of the housing; and
an insulating adhesive sheet interposed between the inner lead and the heat sink for electrically insulating and thermally coupling the inner lead and the heat sink.

2. The high power LED package of claim 1, wherein the insulating adhesive sheet comprises a base film made of an insulating material and adhesive layers arranged on a top and a bottom of the base film.

3. The high power LED package of claim 2, wherein the base film is a polyimide film having a glass transition temperature of more than 260°C.

4. The high power LED package of claim 2, wherein the adhesive layers are formed by coating a polyimide-like adhesive containing an acid terminal group.

5. The high power LED package of claim 2, wherein a filler having thermal conductivity and non conductivity is added in the base film and the adhesive layers.

6. The high power LED package of claim 5, wherein the filler comprises one of silica, alumina, and aluminum nitride (AlN).

7. The high power LED package of claim 1, wherein the LED chip is adhered to the exposed portion of the heat sink by using a non-conductive paste.

8. The high power LED package of claim 1, wherein the lens portion comprises a molding portion which is formed by filling insulating resin in the cavity of the housing to seal the LED chip and a lens for covering the molding portion.

9. The high power LED package of claim 8, wherein the molding portion contains a phosphor corresponding to a color of light emitted from the LED chip.

10. The high power LED package of claim 1, wherein the LED chip is electrically connected to the inner lead by using a wire bonding or a flip chip bonding.

11. The high power LED package of claim 1, wherein the cavity of the housing has a cup shape whose diameter is increased as it is higher.

12. The high power LED package of claim 11, wherein a reflecting material is coated on or a reflector made of a metallic material is coupled to an inner side of the cavity of the housing.

13. The high power LED package of claim 1, wherein the housing has a Zener diode mounting portion in which a Zener diode is mounted.

14. A light emitting diode ("LED") package, comprising:
a housing including an LED chip mounting portion, lead frame contact portions for electrical contact with an LED chip, a Zener diode mounting portion, a lead frame connecting portion formed on its side, and a heat sink adhering portion, wherein the lead frame connecting portion and the heat sink adhering portion have a cavity;
a lead frame coupled through the lead frame connecting portion;
a heat sink adhered through the heat sink adhering portion; and
an insulating adhesive sheet for adhering the lead frame and the heat sink.

15. The LED package of claim 14, wherein the LED chip mounting portion has a concave shape whose diameter is smaller as it is lower.

16. The LED package of claim 14, wherein the lead frame contact portion and the Zener diode mounting portion are patterned into one area.

17. The LED package of claim 14, wherein the LED chip is electrically connected through its bottom portion.
